# EUROPÄISCHE PATENTSCHRIFT

(11) **EP 0 531 646 B1**
(45) Veröffentlichungstag und Bekanntmachung des Hinweises auf die Patenterteilung: **19.03.1997**
(21) Anmeldenummer: 92111386.6
(22) Anmeldetag: 04.07.1992
(51) Int. Cl.: H03K 17/94, G01S 17/02, E03C 1/05

(54) **Schaltungsanordnung zur berührunglosen Steuerung einer Sanitärarmatur sowie Verfahren zum Betreiben einer solchen**
Circuit arrangement for contactless controlling of a sanitary fitting and method for driving
Circuit de commande sans contact d'une armature sanitaire et procédé de commande de celui-ci

(30) Priorität: 31.07.1991 DE 4125288
(43) Veröffentlichungstag der Anmeldung: 17.03.1993
(73) Patentinhaber: HANSA METALLWERKE AG, D-70567 Stuttgart (DE)
(72) Erfinder: Kunkel, Horst, W-7060 Schorndorf-Miedelsbach (DE)
(74) Vertreter: Ostertag, Reinhard

(56) Entgegenhaltungen:
- EP-A- 0 206 334
- EP-A- 0 400 688
- EP-A- 0 463 440
- WO-A-90/14473
- DE-B- 2 836 734
- US-A- 4 207 466
- US-A- 4 921 211
- PATENT ABSTRACTS OF JAPAN, Bd. 10, Nr. 334 (P-515)(2390) 13. November 1986;& JP-A-61139776
- PATENT ABSTRACTS OF JAPAN, Bd. 8, Nr. 276 (M-346)(1713) 18. Dezember 1984;& JP-A-59147178

## Beschreibung

Die Erfindung betrifft eine Schaltungsanordnung zur berührunglosen Steuerung einer Sanitärarmatur mit
a) einem Sender, der eine Strahlung in einen Überwachungsraum aussendet;
b) einem Generator, der die zum Betrieb des Sender erforderlichen elektrischen Signale erzeugt;
c) einem Empfänger, der aus dem Überwachungsraum reflektierte Strahlung empfängt;
d) einer Auswertschaltung, welcher die Ausgangssignale des Empfängers zugeführt werden und die nach vorgegebenen logischen Bedingungen ein Signal zur Ansteuerung eines Magnetventiles bereitstellt, welches den Wasserfluß durch die Sanitärarmatur steuert.

Die Erfindung betrifft außerdem ein Verfahren zum Betreiben einer Schaltungsanordnung zur berührungslosen Steuerung einer Sanitärarmatur mit
a) einem Sender, der eine Strahlung in einen Überwachungsraum aussendet;
b) einem Empfänger, der aus dem Überwachungsraum reflektierte Strahlung empfängt,
bei welchem die Schaltungsanordnung nach der Erzeugung eines Ausgangssignales des Empfängers ein eigenes Ausgangssignal zur Ansteuerung eines Magnetventiles bereitstellt.

Bei bekannten Schaltungsanordnungen dieser Art, wie sie in vielfältiger Ausgestaltung derzeit auf dem Markt und beispielsweise in der DE-AS 28 36 734 beschrieben sind, ergeben sich Probleme, wenn sich der Benutzer bzw. ein Gegenstand in den Randzonen des Überwachungsraumes befindet. Dann kann es zu unkontrollierten raschen Einund Ausschaltvorgängen des Magnetventiles kommen. Dies gilt insbesondere, wenn der Überwachungsraum bei wenig gerichteten Strahlen des Senders nicht scharf begrenzt ist, also ein größerer Überwachungsraum vorgesehen ist. In ähnlicher Weise kann der Wasserstrahl der Sanitärarmatur selbst, wenn er sich im Überwachungsraum befindet, aufgrund der von ihm bewirkten Veränderung der Reflexion zu einem raschen Öffnen und Schließen des Magnetventiles führen.

Aufgabe der vorliegenden Erfindung ist es, eine Schaltungsanordnung der eingangs genannten Art bzw. ein Verfahren zum Betreiben einer solchen Schaltungsanordnung anzugeben, bei welcher bzw. welchem eine stabile, von Flattern freie Funktion des Magnetventiles gewährleistet ist.

Diese Aufgabe wird, was die Schaltungsanordnung angeht, dadurch gelöst, daß
e) sie einen Taktgeber umfaßt, der Taktsignale mit einer bestimmten Taktfrequenz erzeugt;
f) der Generator von dem Taktgeber derart beaufschlagt ist, daß er seine Ausgangssignale in diesem Takt an den Sender abgibt;
g) die Auswertschaltung umfaßt:
   ga) einen ersten Speicher, in welchem eine erste ganze Zahl abspeicherbar ist;
   gb) einen zweiten Speicher, in dem eine zweite ganze Zahl abspeicherbar ist, die kleiner oder gleich der ersten Zahl ist;
   gc) einen logischen Steuerkreis, welcher zyklisch wiederkehrend die Ausgangssignale des Empfängers während einer bestimmten Zahl von Taktimpulsen, die größer oder gleich der im ersten Speicher abgelegten ganzen Zahl ist, zählt, und ein erstes Ausgangssignal abgibt, wenn diese Zählung eine Zahl ergibt, die größer oder gleich der im ersten Speicher abgelegten ersten Zahl ist, und nach dem Bereitstellen des ersten Ausgangssignales ein zweites Ausgangssignal abgibt, wenn die Zählung eine Zahl ergibt, die kleiner als die im zweiten Speicher abgelegte ganze Zahl ist,
wobei das erste Ausgangssignal des logischen Steuerkreises ein Öffnen und das zweite Ausgangssignal ein Schließen des Magnetventiles bewirkt.

Durch den im Takt des Taktgebers gepulsten Betrieb des Senders wird es möglich, vor dem Auslösen der Sanitärarmatur bzw. von dessen Magnetventil eine statistische Auswertung der von dem Empfänger erzeugten Ausgangssignale ("positive Detektionen") vorzunehmen. Bei dieser statistischen Auswertung wird die Zahl der Ausgangssignale des Empfängers in ein Verhältnis zu einer bestimmten Anzahl von Taktimpulsen gesetzt, die natürlich gleich der Anzahl von im selben Zeitraum abgegebenen Impulse des Senders ist. Wird also für N abgegebene Senderimpulse eine bestimmte Mindestanzahl N₁-Impulse des Empfängers erzielt oder überschritten, so wertet dies die Schaltungsanordnung als "echten" Auslösefall und erzeugt das Signal, welches das Öffnen des Magnetventiles bewirkt. Wird die kritische Zahl N₁ von Impulsen des Empfängers, gerechnet auf die Zahl N von Senderimpulsen, nicht erzielt, so deutet dies die Schaltungsanordnung als vorübergehendes Phänomen, welches noch nicht zu einer Auslösung der Sanitärarmatur führen soll. Ein entsprechendes Ausgangssignal wird daher auch noch nicht erzeugt.

Umgekehrt wird durch die Schaltungsanordnung auch das Magnetventil nicht sofort wieder geschlossen, wenn nur einmal ein Ausgangssignal des Empfängers ausbleibt. Vielmehr wird erneut über eine bestimmte Anzahl N von Senderimpulsen hinweg gezählt, wie viele Ausgangssignale der Empfänger erzeugt (wie oft ein Ausgangssignal des Empfängers ausbleibt). Unterschreitet diese Zählung einen bestimmten zweiten Wert N₂ (bleibt also das Ausgangssignal in mindestens N - N₂ Fällen aus), dann wertet dies die Schaltungsanordnung als "echten" Fall des Schließens des Magnetventiles, und beantwortet dies mit der Bereitstellung eines entsprechenden Ausgangssignales. Bleibt das Ausgangssignal des Empfängers jedoch nicht in einer ausreichenden Anzahl von Fällen aus, so wertet die Schaltungsanordnung das entsprechende Ausbleiben von Empfängersignalen als nur vorübergehendes Phänomen, welches ignoriert wird.

Im einfachsten Falle kann die statistische Schwelle N₁, bei welcher das Öffnen des Magnetventiles bewirkt wird, gleich der statistischen Schwelle N₂ gewählt werden, bei welcher das Magnetventil wieder geschlossen wird. Dies eröffnet den Weg zu dem besonders einfachen apparativen Aufbau, bei welchem die beiden Speicher physisch durch dasselbe Bauelement verkörpert sind.

Bevorzugt wird aber diejenige Ausführungsform der Erfindung, bei welcher die im zweiten Speicher abgelegte Zahl kleiner als die im ersten Speicher abgelegte Zahl ist. Dies bedeutet, daß die auf N Senderimpulsen gezählte Zahl N_{Z} von Empfängerimpulsen auf einen kleineren Wert (nämlich eben N₂) absinken muß, wenn das Magnetventil geschlossen werden soll, als es demjenigen Wert N₁ entspricht, der zum Öffnen des Magnetventiles erforderlich war. Auf diese Weise ergibt sich eine Hysteresis der Betriebsweise der Schaltungsanordnung, welche eine Instabilität in Grenzbereichen weiter verhindert.

Die im ersten Speicher abgelegte Zahl kann im Extremfall gleich der Zahl von Taktimpulsen sein, über welche jeweils die Zählung der von dem Empfänger abgegebenen Signale erfolgt. Dies bedeutet, daß zum Öffnen des Magnetventiles jedem von N aufeinanderfolgenden Taktimpulsen und damit auch Senderimpulsen ein Ausgangssignal des Empfängers entsprechen muß. Fällt nur bei einem einzigen Senderimpuls das Ausgangssignal des Empfängers weg, findet bereits kein Öffnen des Magnetventiles mehr statt.

Das erfindungsgemäße Verfahren zum Betreiben einer Schaltungsanordnung der eingangs genannten Art zeichnet sich dadurch aus, daß
c) der Sender gepulst mit einer bestimmten Taktfrequenz betrieben wird;
d) zyklisch wiederkehrend während einer bestimmten Anzahl von Impulsen des Senders die Anzahl von Impulsen des Empfängers gezählt wird;
e) ein erstes Ausgangssignal zum Öffnen des Magnetventiles erzeugt wird, wenn die bei der Zählung ermittelte Zahl von Impulsen des Empfängers größer als eine erste vorgegebene, in einem ersten Speicher abgespeicherte ganze Zahl ist, die kleiner oder gleich der Zahl von Taktimpulsen ist;
f) nach dem Erzeugen des ersten Ausgangssignales ein zweites Ausgangssignal zum Schließen des Magnetventiles erzeugt wird, wenn die bei der Zählung ermittelte Zahl von Impulsen des Empfängers kleiner als eine zweite vorgegebene, in einem zweiten Speicher abgespeicherte ganze Zahl ist, die kleiner oder gleich der ersten ganzen Zahl ist.

Die Vorteile des erfindungsgemäßen Verfahrens entsprechen sinngemäß denjenigen, die oben für eine erfindungsgemäße Schaltungsanordnung beschrieben wurden.

Ein Ausführungsbeispiel der Erfindung wird nachfolgend anhand der Zeichnung näher erläutert; es zeigen
- Figur 1:: schematisch das Blockdiagramm einer Schaltungsanordnung zur berührungslosen Steuerung einer Sanitärarmatur;
- Figur 2:: das Flußdiagramm zur Veranschaulichung der tionsabläufe in der Schaltungsanordnung von Figur 1.

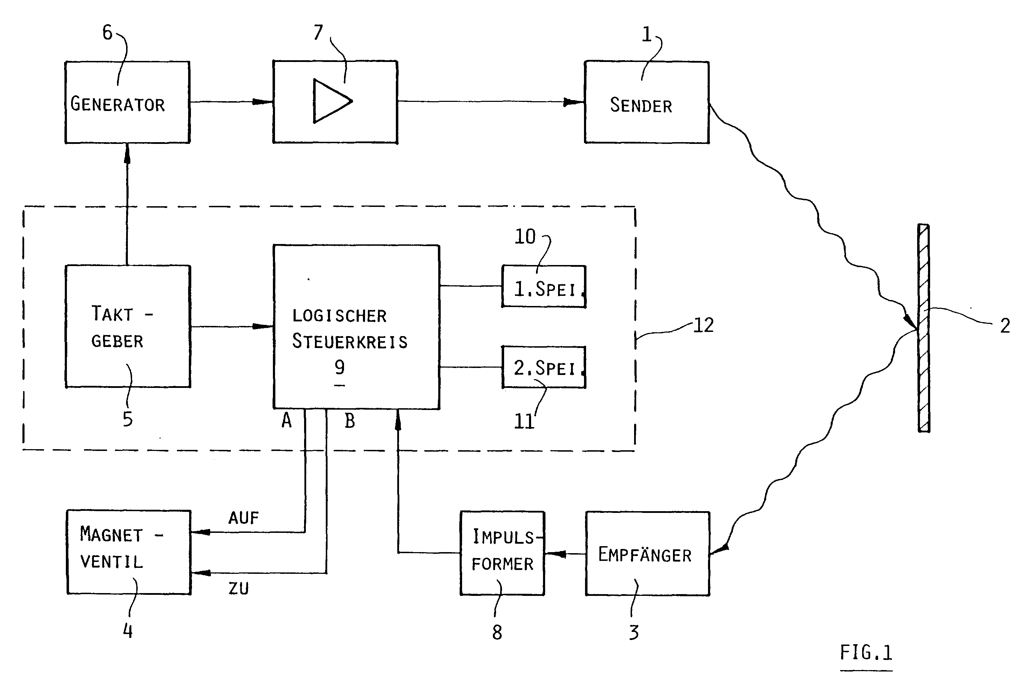

Die in Figur 1 schematisch dargestellte Schaltungsanordnung zur berührungslosen Steuerung einer Sanitärarmatur umfaßt in an und für sich bekannter Weise einen Sender 1, der Strahlung in einen Überwachungsbereich abgibt. Befindet sich in dem Überwachungsbereich ein Gegenstand 2, z.B. ein Benutzer, so wird die Strahlung an diesem reflektiert und gelangt auf einen Empfänger 3. Hierdurch wird in noch näher zu beschreibender Weise das Magnetventil 4 gesteuert, welches den Wasserfluß zu einem Auslauf beherrscht.

Der Sender 1 wird von einer Folge modulierter Impulse gespeist. Die Taktfrequenz sowie ggf. das Taktverhältnis werden von einem freilaufenden Taktgeber 5 vorgegeben, dessen Taktperiode beispielsweise 0,2 sec betragen kann. Der Taktgeber 5 beaufschlagt einen Generator 6, der in dem von dem Taktgeber 5 vorgegebenen Takt Impulse mit einer Frequenz erzeugt, die gegenüber der Taktfrequenz des Taktgebers 5 verhältnismäßig hoch ist. Die so entstandenen modulierten Impulse werden vom Verstärker 7 auf die vom Sender 1 benötigte Leistung gebracht.

Die vom Empfänger 3 empfangenen Signale werden auf einen Impulsformer 8 gegeben, in dem beispielsweise ein Schwellwertschalter enthalten sein kann. Die Ausgangssignale des Impulsformers 8 werden zur logischen Verarbeitung einem logischen Steuerkreis 9 zugeleitet. Der logische Steuerkreis 9 steht mit einem ersten Speicher 10 und einem zweiten Speicher 11 in Verbindung, in denen vorwählbare Zahlen abspeicherbar sind; deren Sinn und Funktion wird weiter unten deutlich werden. Der Taktgeber 5, der logische Steuerkreis 9 und die beiden Speicher 10 und 11 können körperlich in einem handelsüblichen Mikroprozessor vereinigt sein, was durch die gestrichelte Einrahmung 12 angedeutet ist.

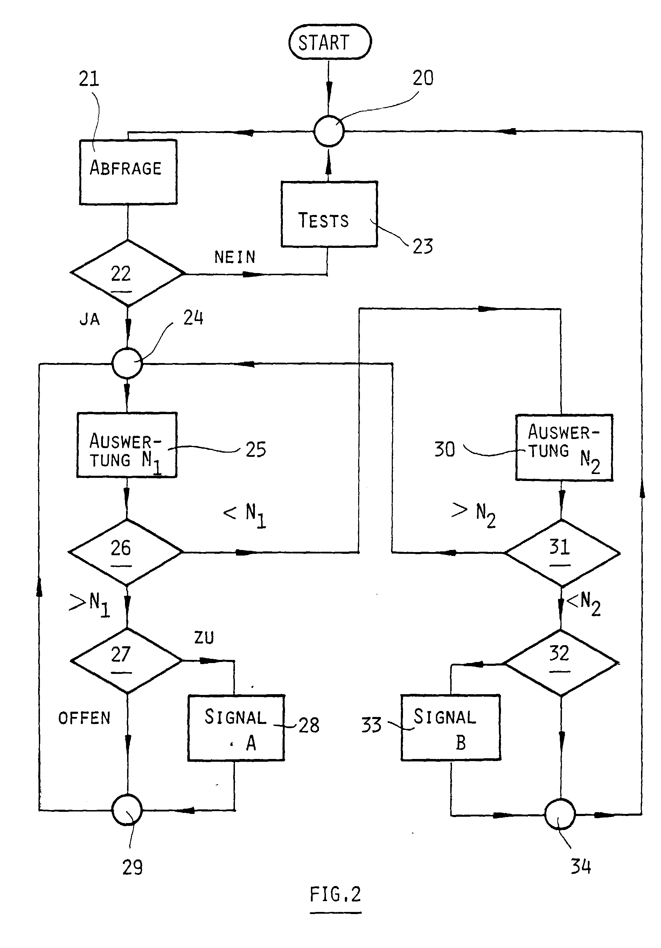

In Abhängigkeit von einer Logik, die weiter unten anhand der Figur 2 näher erläutert wird, erzeugt der logische Steuerkreis 9 an einem Ausgang A ein Signal, welches dem Magnetventil 4 zugeführt wird und dessen Öffnung bewirkt. Alternativ kann der logische Steuerkreis 9 an einem Ausgang B ein Signal erzeugen, welches ebenfalls dem Magnetventil 4 zugeführt wird und dessen Schließung zur Folge hat.

Die Funktionsabläufe und somit die Logik, in welcher der logische Steuerkreis 9 von Figur 1 in Abhängigkeit von den ihm vom Impulsformer 8 zugeführten Impulsen das Magnetventil 4 steuert, ist dem Flußdiagramm von Figur 2 zu entnehmen. Dieses wird in dem vom Taktgeber 5 vorgegebenen Takt wie folgt durchlaufen:

Nach dem Einschalten der elektronischen Schaltungsanordnung befindet sich die Steuerung zunächst am Punkt 20. Beim nächsten Takt des Taktgebers wird im Kästchen 21 die Sensorik abgefragt, das heißt, es wird geprüft, ob der Empfänger 3 einen reflektiertes Signal erhalten hat, welches vom Impulsformer 8 in ein gültiges, dem logischen Schaltkreis 9 zugeführtes Signal umgeformt wurde. Ist dies nicht der Fall, so schaltet die Steuerung zum Kästchen 22, in welchem bestimmte Systemtests durchgeführt werden können. Von dem Kästchen 22 kehrt dann die Steuerung wieder zum Ausgangspunkt 20 zurück. Die Punkte 20, 21, 22, 23 werden zyklisch solange durchlaufen, bis sich bei der Abfrage 21 eine "positive Detektion" ergibt, also festgestellt wird, daß der Impulsformer 8 ein gültiges Signal an den logischen Steuerkreis 9 abgegeben hat. Ist dies der Fall, geht die Steuerung vom Verzweigungspunkt 22 über den Punkt 24 zum Kästchen 25 über. Im Kästchen 25 findet eine statistische Auswertung der nacheinander eintreffenden Impulse statt. Hierzu wird die Zahl N_{Z} der aufeinander folgenden Impulse während N Taktimpulsen, also während N Impulsen des Senders 1 ermittelt. Ist diese Zahl N_{Z} kleiner als eine Zahl N₁, die im ersten Speicher 10 abgespeichert ist, so wird der sich vor dem Sender 1 und dem Empfänger 3 abspielende Vorgang, der zu den positiven Detektionen geführt hat, nur als vorübergehend gewertet; das Magnetventil 4 wird nicht geöffnet; die Steuerung wechselt am Verzweigungspunkt 26 in einen in Figur 2 rechts dargestellten Zweig des Funktionsdiamgrammes, der weiter unten erläutert wird.

Überschreitet dagegen die innerhalb von N Taktimpulsen gezählte Zahl N_{Z} von positiven Detektionen den im Speicher 1 abgelegten Wert N₁, so geht die Steuerung vom Verzweigungspunkt 26 zum Verzweigungspunkt 27 über, in welchem der aktuelle Zustand des Magnetventiles 4 geprüft wird. Ist das Magnetventil 4 geschlossen, was normalerweise nach dem erstmaligen Start der Schaltungsanordnung der Fall sein wird, schreitet die Steuerung zum Kästchen 28, in welchem der logische Steuerkreis 9 ein Ausgangssignal am Ausgang A bereitstellt, welches bekanntlich das Magnetventil 4 öffnet. Die Steuerung geht dann über den Punkt 29 zum Punkt 24 zurück.

Ist bei der im Verzweigungspunkt 27 stattfindenden Prüfung das Magnetventil 4 bereits offen, geht die Steuerung an dem Kästchen 28 vorbei direkt zum Punkt 29 und zum Punkt 24.

Die Steuerung bewegt sich nunmehr zyklisch in der Schleife, welche von dem Punkt 24 über die Auswertung 25, die Verzweigungspunkte 26 und 27, den Punkt 29 und zurück zum Punkt 24 führt. Diese Schleife wird solange durchlaufen, bis bei der Passage des Kästchens 25 in der statistischen Auswertung die Zahl N_{Z} der während N aufeinander folgender Taktimpulse ermittelter Detektionen nicht mehr die im ersten Speicher 10 abgelegte Zahl N₁ überschreitet. Dann verläßt die Steuerung die genannte Schleife am Verzweigungspunkt 26 und geht nunmehr zu dem in Figur 2 rechts dargestellten Zweig.

In diesem wird zunächst das Kästchen 30 erreicht, in dem erneut eine statistische Auswertung vorgenommen wird, welche der statistischen Auswertung im Kästchen 25 ähnelt. Erneut wird geprüft, wieviele positive Detektionen während N aufeinanderfolgender Taktimpulse ermittelt werden. Die so ermittelte Zahl N_{Z} positiver Detektionen wird nunmehr aber mit einem im Speicher 11 abgelegten zweiten Zahlenwert N₂ verglichen, der kleiner als der im Speicher 10 abgelegte Zahlenwert N₁ ist. Wird dieser kleinere Zahlenwert N₂ überschritten, kehrt die Steuerung am Verzweigungspunkt 31 wiederum zum Punkt 24 im linken Zweig des Flußdiagrammes zurück; der logische Steuerkreis 9 wertet also das Absinken der Zahl N_{Z} der positiven Detektionen unter den Wert N₁ noch nicht als statistisch signifikant sondern als "Ausrutscher" und sieht davon ab, den Wasserfluß bereits bei solchen Zahlen N_{Z} positiver Detektionen innerhalb von N aufeinanderfolgenden Taktimpulsen abzustellen, die zwischen N₁ und N₂ liegen. Auf diese Weise erhält die gesamte Steuerung eine gewisse Hysterese, die verhindert, daß eine geringfügige Hin- und Herbewegung eines Benutzers vor der Sanitärarmatur oder ähnliche, nur vorübergehende Vorgänge zu einem übereilten Schließen des Magnetventiles 4 führen.

Nach einem solchen nur vorübergehenden Absinken der Zahl N_{Z} positiver Detektionen während N aufeinanderfolgender Taktimpulse kann also erneut die Schleife über die Punkte 24, 25, 26, 27, 29, 24 durchlaufen werden, bis wiederum die Auswertung im Kästchen 25 ergibt, daß während N aufeinanderfolgender Taktimpulse nicht mehr die Zahl N₁ positiver Detektionen erreicht wird. Erneut wechselt dann die Steuerung auf den in Figur 2 rechts dargestellten Zweig über.

Diesmal sei angenommen, daß die Auswertung im Kästchen 30 eine Zahl N_{Z} positiver Detektionen innerhalb N aufeinanderfolgender Taktimpulse ergibt, die den Wert N₂ nicht mehr erreicht. Jetzt geht die Steuerung am Verzweigungspunkt 31 zum Verzweigungspunkt 32 weiter, in welchem geprüft wird, ob das Magnetventil 4 geschlossen oder offen ist. Normalerweise ist beim erstmaligen Erreichen des Verzweigungspunktes 32 nach dem oben Gesagten das Magnetventil 4 offen. Die Steuerung schreitet deshalb zum Kästchen 33, in welchem der logische Steuerkreis 9 an seinem Ausgang B ein Signal bereitstellt, welches das Magnetventil 4 schließt. Nach dem Schließen des Magnetventiles 4 kehrt die Steuerung über den Punkt 34 wieder zum Ausgangspunkt 20 zurück.

Durch die beschriebene statistische Auswertung der Signale sowohl vor dem Öffnen als auch vor dem Schließen des Magnetventiles 4 werden vorübergehende, schnell wechselnde Auslösungen des Magnetventiles 4 vermieden, die insbesondere dann auftreten können, wenn sich der Benutzer oder ein sonstiger Gegenstand an der Grenze des Erfassungsbereiches der Schaltungsanordnung befindet.

## Patentansprüche

1. Schaltungsanordnung zur berührungslosen Steuerung einer Sanitärarmatur mit
a) einem Sender, der eine Strahlung in einen Überwachungsraum aussendet;
b) einem Generator, der die zum Betrieb des Senders erforderlichen elektrischen Signale erzeugt;
c) einem Empfänger, der aus dem Überwachungsraum reflektierte Strahlung empfängt;
d) einer Auswertschaltung, welcher die Ausgangangssignale des Empfängers zugeführt werden und die nach vorgegebenen logischen Bedingungen ein Signal zur Ansteuerung eines Magnetventiles bereitstellt, welches den Wasserfluß durch die Sanitärarmatur steuert,
dadurch gekennzeichnet, daß
e) sie einen Taktgeber (5) umfaßt, der Taktsignale mit einer bestimmten Taktfrequenz erzeugt;
f) der Generator (6) von den Taktsignalen des Taktgebers (5) derart beaufschlagt ist, daß er seine Ausgangssignale in diesem Takt an den Sender (1) abgibt;
g) die Auswertschaltung umfaßt:
ga) einen ersten Speicher (10), in welchem eine erste ganze Zahl (N₁) abspeicherbar ist;
gb) einen zweiten Speicher (11), in dem eine zweite ganze Zahl (N₂) abspeicherbar ist, die kleiner oder gleich der ersten Zahl (N₁) ist;
gc) einen logischen Steuerkreis (9), welcher zyklisch wiederkehrend die Ausgangssignale des Empfängers (3) während einer bestimmten Zahl (N) von Taktimpulsen, die größer oder gleich der im ersten Speicher abgelegten ganzen Zahl (N₁) ist, zählt und ein erstes Ausgangssignal (A) abgibt, wenn diese Zählung eine Zahl (N_{Z}) ergibt, die größer oder gleich der im ersten Speicher (10) abgelegten ersten Zahl (N₁) ist, und nach dem Bereitstellen des ersten Ausgangssignales (A) ein zweites Ausgangssignal (B) abgibt, wenn die Zählung eine Zahl (N_{Z}) ergibt, die kleiner als die im zweiten Speicher (11) abgelegte ganze Zahl (N₂) ist,
wobei das erste Ausgangssignal (A) des logischen Schaltkreises (9) ein Öffnen und das zweite Ausgangsignal (B) ein Schließen des Magnetventiles (4) bewirkt.

2. Schaltungsanordnung nach Anspruch 1, dadurch gekennzeichnet, daß die in den beiden Speichern (10, 11) abgelegten Zahlen (N₁, N₂) gleich sind.

3. Schaltungsanordnung nach Anspruch 2, dadurch gekennzeichnet, daß die beiden Speicher (10, 11) physisch durch dasselbe Bauelement verkörpert sind.

4. Schaltungsanordnung nach Anspruch 1, dadurch gekennzeichnet, daß die im zweiten Speicher (11) abgelegte Zahl (N₂) kleiner als die im ersten Speicher (10) abgelegte Zahl (N₁) ist.

5. Schaltungsanordnung nach einem der vorhergehenden Ansprüche, dadurch gekennzeichnet, daß die im ersten Speicher (10) abgelegte Zahl (N₁) gleich der Zahl (N) von Taktimpulsen ist, über welche jeweils die Zählung der von dem Empfänger (3) abgegebenen Signale erfolgt.

6. Verfahren zum Betreiben einer Schaltungsanordnung zur berührungslosen Steuerung einer Sanitärarmatur mit
a) einem Sender, der eine Strahlung in einen Überwachungsraum aussendet;
b) einem Empfänger, der aus dem Überwachungsraum reflektierte Strahlung empfängt,
bei welchem die Schaltungsanordnung nach der Erzeugung eines Ausgangssignales des Empfängers ein eigenes Ausgangssignal zur Ansteuerung eines Magnetventiles bereitstellt,
dadurch gekennzeichnet, daß
c) der Sender (1) gepulst mit einer bestimmten Taktfrequenz betrieben wird;
d) zyklisch wiederkehrend während einer bestimmten Anzahl (N) von Impulsen des Senders (1) die Anzahl von Impulsen des Empfängers (3) gezählt wird;
e) ein erstes Ausgangssignal (A) zum Öffnen des Magnetventils (4) erzeugt wird, wenn die bei der Zählung ermittelte Zahl (N_{Z}) von Impulsen des Empfängers (3) größer als eine erste vorgegebene, in einem ersten Speicher abgespeicherte ganze Zahl (N₁) ist, die kleiner oder gleich der Zahl (N) von Taktimpulsen ist;
f) nach dem Erzeugen des ersten Ausgangssignales (A) ein zweites Ausgangssignal (B) zum Schließen des Magnetventils (4) erzeugt wird, wenn die bei der Zählung ermittelte Zahl (N_{Z}) von Impulsen des Empfängers (3) kleiner als eine zweite vorgegebene, in einem zweiten Speicher abgespeicherte ganze Zahl (N₂) ist, die kleiner oder gleich der ersten ganzen Zahl (N₁) ist.

## Claims

1. Circuit arrangement for the contactless control of a sanitary fitting having
a) a transmitter, which transmits radiation into a control room,
b) a generator, which generates the electrical signals necessary for the operation of the transmitter,
c) a receiver, which receives the radiation reflected from the control room,
d) an evaluating circuit to which are supplied the output signals of the receiver and which according to predetermined logic conditions makes available a signal for controlling a solenoid valve, which controls the water flow through the sanitary fitting,
characterized in that
e) it comprises a clock generator (5), which generates clock signals with a specific clock frequency,
f) the clock signals of the clock generator (5) are supplied to the generator (6) in such a way that it delivers its output signals in said clock cycle to the transmitter (1),
g) the evaluating circuit comprises:
ga) a first memory (10), in which can be stored a first integer (N₁),
gb) a second memory (11), in which can be stored a second integer (N₂), which is equal to or smaller than the first integer (N₁),
gc) a logic control circuit (9), which in cyclically recurrent manner counts the output signals of the receiver (3) during a given number (N) of clock pulses, which is equal to or larger than the integer (N₁) filed in the first memory and delivers a first output signal (A), if said count gives a number (N_{Z}), which is equal to or larger than the first integer (N₁) filed in the first memory (10) and after making available the first output signal (A) delivers a second output signal (B) if the count gives a number (N_{Z}) which is smaller than the integer (N₂) filed in the second memory (11),
the first output signal (A) of the logic circuit (9) bringing about an opening and the second output signal (B) a closing of the solenoid valve (4).

2. Circuit arrangement according to claim 1, characterized in that the integers (N₁, N₂) filed in the two memories (10, 11) are equal.

3. Circuit arrangement according to claim 2, characterized in that the two memories (10, 11) are physically embodied by the same component.

4. Circuit arrangement according to claim 1, characterized in that the integer (N₂) filed in the second memory (11) is smaller than the integer (N₁) filed in the first memory (10).

5. Circuit arrangement according to one of the preceding claims, characterized in that the integer (N₁) filed in the first memory (10) is equal to the number (N) of clock pulses over which in each case the counting of the signals delivered by the receiver (3) takes place.

6. Method for operating a circuit arrangement for the contactless control of a sanitary fitting having
a) a transmitter transmitting a radiation into a control room,
b) a receiver receiving the radiation reflected from the control room,
in which the circuit arrangement, following the generation of an output signal of the receiver, makes available its own output signal for controlling a solenoid valve,
characterized in that
c) the transmitter (1) is operated in pulsed manner with a given clock frequency,
d) in cyclically recurrent manner during a given number (N) of pulses of the transmitter (1), the number of pulses of the receiver (3) is counted,
e) a first output signal (A) for opening the solenoid valve (4) is generated if the number (N_{Z}) of pulses of the receiver (3) determined during the count is higher than a first predetermined integer (N₁) stored in a first memory and which is equal to or smaller than the number (N) of clock pulses,
f) after generating the first output signal (A) a second output signal (B) is generated for closing the solenoid valve (4), if the number (N_{Z}) of pulses of the receiver (3) determined during the count is smaller than a second, predetermined integer (N₂), stored in a second memory and which is equal to or smaller than the first integer (N₁).

## Revendications

1. Montage de circuits pour la commande sans contact d'un appareil de robinetterie sanitaire, comprenant
a) un émetteur qui émet un rayonnement dans un espace surveillé;
b) un générateur qui génère les signaux électriques nécessaires au fonctionnement de l'émetteur;
c) un récepteur qui reçoit du rayonnement réfléchi à partir de l'espace surveillé; et
d) un circuit d'évaluation auquel sont envoyés les signaux de sortie du récepteur et qui, selon des conditions logiques préfixées, fournit un signal pour la commande d'une électrovanne contrôlant l'écoulement d'eau à travers l'appareil de robinetterie sanitaire,
caractérisé en ce que
e) il comprend une horloge (5) qui génère des signaux d'horloge avec une fréquence d'horloge déterminée;
f) le générateur (6) est alimenté avec les signaux d'horloge de l'horloge (5), de manière qu'il délivre ses signaux de sortie au rythme de ces signaux d'horloge à l'émetteur (1); et
g) le circuit d'évaluation comprend:
ga) une première mémoire (10) dans laquelle peut être stocké un premier nombre entier (N₁);
gb) une seconde mémoire (11) dans laquelle peut être stocké un second nombre entier (N₂) inférieur ou égal au premier nombre (N₁) et
gc) un circuit de commande logique (9) qui, de façon répétée cycliquement, compte les signaux de sortie du récepteur (3) pendant un nombre (N) déterminé d'impulsions d'horloge, qui est supérieur au égal au nombre entier (N₁) stocké dans la première mémoire, et délivre un premier signal de sortie (A) si ce comptage donne un nombre (N_{Z}) supérieur ou égal au premier nombre (N₁) stocké dans la première mémoire (10), et qui, après la fourniture du premier signal de sortie (A), délivre un second signal de sortie (B) si le comptage donne un nombre (N_{Z}) plus petit que le nombre entier (N2) stocké dans la seconde mémoire (11),
le premier signal de sortie (A) du circuit de commande logique (9) produisant l'ouverture et le second signal de sortie (B) provoquant la fermeture de l'électrovanne (4).

2. Montage selon la revendication 1, caractérisé en ce que les nombres (N₁, N₂) stockés dans les deux mémoires (10, 11) sont égaux.

3. Montage selon la revendication 2, caractérisé en ce que les deux mémoires (10, 11) sont matérialisées physiquement par le même composant.

4. Montage selon la revendication 1, caractérisé en ce que le nombre (N₂) stocké dans la seconde mémoire (11) est plus petit que le nombre (N₁) stocké dans la première mémoire (10).

5. Montage selon une des revendications précédentes, caractérisé en ce que le nombre (N₁) stocké dans la première mémoire (10) est égal au nombre (N) d'impulsions d'horloge sur lesquelles s'effectue chaque fois le comptage des signaux délivrés par le récepteur (3).

6. Procédé pour faire fonctionner un montage servant à la commande sans contact d'un appareil de robinetterie sanitaire et comprenant
a) un émetteur qui émet un rayonnement dans un espace surveillé; et
b) un récepteur qui reçoit du rayonnement réfléchi à partir de l'espace surveillé,
procédé selon lequel le montage, après la génération d'un signal de sortie du récepteur, fournit un signal de sortie qui lui est propre pour la commande d'une électrovanne,
caractérisé en ce que
c) l'émetteur (1) est amené à fonctionner de façon pulsée à une fréquence d'horloge déterminée;
d) le nombre d'impulsions du récepteur (3) est compté, de façon répétée cycliquement, pendant un nombre (N) déterminé d'impulsions de l'émetteur (1);
e) un premier signal de sortie (A) est généré pour l'ouverture de l'électrovanne (4) si le nombre (N_{Z}) d'impulsions du récepteur (3) relevé lors du comptage est supérieur à un premier nombre entier (N₁) prédéterminé, stocké dans une première mémoire, premier nombre qui est lui-même inférieur ou égal au nombre (N) d'impulsions d'horloge; et
f) après la génération du premier signal de sortie (A), un second signal de sortie (B) est généré pour la fermeture de l'électrovanne (4) si le nombre (N_{Z}) d'impulsions du récepteur (3) relevé lors du comptage est inférieur à un second nombre entier (N₂) prédéterminé, stocké dans une seconde mémoire, qui est lui-même inférieur ou égal au premier nombre entier (N₁).
